# EUROPÄISCHE PATENTANMELDUNG

(11) **EP 4 529 025 A1**
(43) Veröffentlichungstag der Anmeldung: **26.03.2025**
(21) Anmeldenummer: 24194305.9
(22) Anmeldetag: 13.08.2024
(51) Int. Cl.: H04B 3/00, G11B 17/22

(54) **SYSTEM UND VERFAHREN ZUM BETREIBEN EINES ARINC-429-TRANSMITTERS**

(30) Priorität: 25.09.2023 DE 102023125859
(71) Anmelder: Liebherr-Electronics and Drives GmbH, 88131 Lindau (DE)
(72) Erfinder: WENNDT, Sarah, 88046 Friedrichshafen (DE); GEIPEL, Matthias, 88131 Lindau (DE); HUMMEL, Lars, 88239 Wangen (DE); FELDENGUT, Alexander, 87477 Sulzberg (DE)
(74) Vertreter: Thoma, Michael

(57) **Zusammenfassung**

Die vorliegende Erfindung betrifft ein System zum Betreiben eines ARINC-429-Transmitters, umfassend einen ARINC-429-Transmitter zum Entgegennehmen einer Signalfolge von einer Sendeeinheit und zum Umwandeln der Signalfolge in ein differentielles Ausgangssignal zum Ausgeben an einen Empfänger, und die Sendeeinheit zum Erzeugen einer Signalfolge für den ARINC-429-Transmitter. Das System ist dadurch gekennzeichnet, dass der ARINC-429-Transmitter in Abhängigkeit einer empfangenen Signalfolge von der Sendeeinheit dazu ausgelegt ist, ein Ausgangssignal mit einer hohen oder einer niedrigen Übertragungsrate an den Empfänger zu senden, vorzugsweise wobei die Datenübertragungsrate bei niedriger Übertragungsrate im Bereich von 12 - 14,5 kb/s ±1% und die Datenübertragungsrate bei hoher Übertragungsrate 100 kb/s ±1% ist.

Die Erfindung betrifft darüber hinaus auch ein Verfahren zum Betreiben eines ARINC-429-Transmitters.

## Beschreibung

Die vorliegende Erfindung betrifft ein System und ein Verfahren zum Betreiben eines ARINC-429-Transmitters.

Die vorliegende Erfindung bezieht sich auf Avionikdatenübertragungssysteme mit einem nach der Erfindung verbesserten ARINC-429 Transmitter.

ARINC-429 ist ein technischer Standard für die Datenkommunikation in Luftfahrtzeugen und definiert die physische und elektrische Schnittstelle sowie das Datenprotokoll für Avionik-Datensysteme. Der Name "ARINC 429" stammt von der Firma "Aeronautical Radio, Incorporated" (ARINC), die eine Vielzahl von Standards für die Flugzeugindustrie entwickelt hat.

Die ARINC-429 Schnittstelle ist in der kommerziellen Luftfahrt weit verbreitet und ermöglicht die Übertragung von Daten zwischen Avioniksystemen in einem Punktzu-Punkt-Modus mit festgelegten Datenraten.

Trotz ihrer breiten Akzeptanz und Anwendung in zahlreichen Flugzeugen bringt die ARINC-429 Schnittstelle auch gewisse Nachteile mit sich. So gibt es bei einer ARINC-429-Schnittstelle die Möglichkeit, mit zwei unterschiedlichen Datenübertragungsraten zu operieren, wobei die niedrigere Datenübertragungsrate im Bereich zwischen 12-14,5 kb/s und die höhere Datenübertragungsrate bei 100 kb/s ±1% liegt.

In der Regel ist eine ARINC-429-Schnittstelle so vorkonfiguriert, dass sie mit einer der beiden Geschwindigkeiten betrieben wird, sodass ein Ändern der Datenübertragungsgeschwindigkeit nicht vorgesehen ist. Es gibt jedoch auch die Möglichkeit, eine Kommunikation nach dem ARINC-429-Standard vorzunehmen, bei der die Datenübertragungsgeschwindigkeit zwischen der niedrigen und der hohen Übertragungsgeschwindigkeit umschaltbar ist. Dabei kann ein kommerziell verwendeter ARINC-429 -Treiberbaustein verwendet werden, welcher über einen dedizierten Input-Pin verfügt, mit welchem die Slewrate gemäß ARINC-429 Standard umgestellt werden kann. Durch das Verändern der Slewrate kann also zwischen der niedrigeren Übertragungsrate und der höheren Übertragungsrate gewechselt werden. Nachteilhaft hieran ist, dass diese Umsetzung kostenintensiv ist und darüber hinaus das Vorhandensein des zusätzlichen Pins (mit entsprechender Verschaltung und Ansteuerungen) erfordert.

Das Ziel der vorliegenden Erfindung ist es, einen ARINC-429-Transmitter zu schaffen, der die oben beschriebenen Nachteile bei einem Wechsel der Datenübertragungsgeschwindigkeit überwindet oder zumindest abmildert. Dies gelingt mit einem erfindungsgemäßen System zum Betreiben eines ARINC-429-Transmitters nach dem Anspruch 1 bzw. mit einem Verfahren zum Betreiben eines ARINC-429-Transmitters nach dem Anspruch 12. Vorteilhafte Ausgestaltungen der vorliegenden Erfindung sind dabei in den jeweiligen abhängigen Ansprüchen niedergeschrieben.

Nach der Erfindung ist vorgesehen, dass das erfindungsgemäße System einen ARINC-429-Transmitter zum Entgegennehmen einer Signalfolge von einer Sendeeinheit und zum Umwandeln der Signalfolge in ein differentielles Ausgangssignal zum Ausgeben an einen Empfänger und die Sendeeinheit zum Erzeugen einer Signalfolge für den ARINC-429-Transmitter umfasst. Das System ist dadurch gekennzeichnet, dass der ARINC-429-Transmitter in Abhängigkeit einer empfangenen Signalfolge von der Sendeeinheit dazu ausgelegt ist, ein Ausgangssignal mit einer hohen oder einer niedrigen Übertragungsrate an den Empfänger zu senden, vorzugsweise wobei die Datenübertragungsrate standardkonform bei niedriger Übertragungsrate zwischen 12 - 14,5kbps +-1%, vorzugsweise 12,5kbps und bei hoher Übertragungsrate 100kbps +-1% ist.

Im Gegensatz zur bisherigen Umsetzung zum Umschalten eines Wechsels zwischen den beiden Datenübertragungsgeschwindigkeiten ist nunmehr kein zusätzlicher Pin an der Sendeeinheit mehr erforderlich, da der Wechsel der Datenübertragungsgeschwindigkeit über das vom ARINC-429-Transmitter zu wandelnde Signal direkt übermittelt wird. Der ARINC-429-Transmitter selbst ändert also gar nicht seine tatsächliche Datenübertragungsgeschwindigkeit, sondern wird in Bezug auf die von ihm zu verarbeitende Signalfolge auf eine spezifische Art und Weise angesteuert, sodass am Ausgang des ARINC-429-Transmitters sowohl eine Datenübertragung mit hoher Geschwindigkeit wie auch eine Datenübertragung mit niedriger Geschwindigkeit möglich ist. Vorteilhaft hierbei ist, dass man keine hardwareseitigen Veränderungen an dem ARINC-429-Transmitter vornehmen muss, sondern lediglich die mit dem ARINC-429-Transmitter in Verbindung stehende Sendeeinheit entsprechend auszubilden hat. Bei einer Kommunikation mit der hohen Datenübertragungsgeschwindigkeit wird eine standardgemäße Signalisierung von der Sendeeinheit an den ARINC-429-Transmitter übertragen, wobei diese regulär verarbeitet wird. Ist es dann bspw. gewünscht, den ARINC-429-Transmitter mit einer niedrigen Datenübertragungsgeschwindigkeit zu nutzen, wird eine davon abweichende Signalfolge an den ARINC-429-Transmitter gesendet, die bewirkt, dass der ARINC-429-Transmitter ein Ausgangssignal mit der niedrigeren Datenübertragungsrate ausgibt. Das erfindungsgemäße System kann unabhängig von der Datenrate und der daraus resultierenden Frequenz betrieben werden. Es werden keine zusätzlichen Pins zur Geschwindigkeitsregulierung benötigt und es können signifikant Kosten eingespart werden, da kein integrierter Baustein verwendet werden muss. Zudem ermöglicht die erfindungsmäße Umsetzung gleichzeitig auch eine verbesserte Flexibilität im Design.

Die grundlegende Idee der vorliegenden Erfindung liegt nun darin, dass die Ausgabe des ARINC-429-Transmitters mit einer hohen Datenübertragungsrate bzw. mit einer niedrigeren Datenübertragungsrate allein dadurch geändert werden kann, dass die durch den ARINC-429-Transmitter zu wandelnde Signalfolge entsprechend modifiziert wird und keine separate Signalisierungsleitung erforderlich ist, die dem ARINC-429-Transmitter zwischen einem ersten Verarbeitungsmodus mit niedriger Datenübertragungsrate und einem zweiten Verarbeitungsmodus mit hoher Datenübertragungsrate umschaltet.

Nach einer vorteilhaften Modifikation der vorliegenden Erfindung kann vorgesehen sein, dass der ARINC-429-Transmitter so konfiguriert ist, dass er dazu in der Lage ist, ein Ausgangssignal mit einer hohen Übertragungsrate an den Empfänger zu senden. Die Grundkonfiguration des ARINC-429-Transmitters ist demnach derart eingestellt, dass eine Datenübertragung mit hoher Geschwindigkeit durchgeführt wird. Eine spezifische an den ARINC-429-Transmitter gesendete Signalfolge bewirkt dann ein Ausgangssignal des eigentlich auf hohe Datenübertragungsgeschwindigkeit konfigurierten Transmitters, welches einem Transmitter mit niedriger Datenübertragungsgeschwindigkeit entspricht. Es ist somit Kompatibilität zu Systemen hergestellt, die eine hohe und/oder eine niedrige Datenübertragungsgeschwindigkeit benötigen.

Nach der Erfindung kann ferner vorgesehen sein, dass die Sendeeinheit dazu ausgelegt ist, dann, wenn der ARINC-429 Transmitter mit der niedrigen Übertragungsrate zu betreiben ist, die an den ARINC-429-Transmitter zu sendende Signalfolge in ihren steigenden und fallenden Flanken zu modifizieren.

Durch das Modifizieren des von der Sendeeinheit gesendeten Signals hinsichtlich seiner Zustandswechsel wird am Ausgang des ARINC-429-Transmitters eine gegenüber der hohen Datenübertragungsgeschwindigkeit langsam ansteigende Ausgangsflanke erzeugt, die demjenigen Ausgangssignal entspricht, das sich bei einer niedrigen Datenübertragungsgeschwindigkeit einstellen würde. Entsprechende Abnehmer des von dem ARINC-429-Transmitters so erzeugten Ausgangssignals nehmen das so erzeugte Ausgangssignal als ein Signal war, welches durch den Transmitter mit niedriger Datenübertragungsgeschwindigkeit erzeugt worden ist, da die Flanke die hierfür typische Steigung besitzt. Das Modifizieren der Signalflanke von einem Wechsel zwischen dem Low-Zustand und dem High-Zustand kann sich nach einer vorteilhaften Ausgestaltung der vorliegenden Erfindung dabei über mindestens 5 µs, vorzugsweise mindestens 8 µs und bevorzugterweise mindestens 10 µs erstrecken. Ferner kann dabei vorgesehen sein, dass der Wechsel nicht länger als 15µs dauert.

Nach einer optionalen Modifikation der vorliegenden Erfindung kann vorgesehen sein, dass die Signalfolge der Sendeeinheit mindestens ein Rechtecksignal, insbesondere ausschließlich Rechtecksignale, darstellt, wobei deren Flanken (und natürlich auch deren Dauer und der Abstände der Rechtecksignale untereinander) in Abhängigkeit davon, ob der ARINC-429-Transmitter mit hoher Übertragungsrate oder mit niedriger Übertragungsrate zu betreiben ist, modifiziert sind oder nicht. Ander ausgedrückt wird die Symbolzeit des von dem Transmitter ausgegebenen Symbols modifiziert.

Der ARINC-429-Standard verwendet zum Ansteuern des ARINC-429-Transmitters in der Regel lediglich Rechtecksignale, wobei vorgesehen sein kann, dass es zwei separate Eingangsleitungen zu dem Transmitter gibt. Das Senden eines Rechtecksignals auf einer ersten der beiden separaten Eingangsleitungen führt dann dazu, dass an der Ausgangsleitung des ARINC-429-Transmitters eine logische 1 gesendet wird, wohingegen das Senden eines Rechtecksignals auf der anderen der beiden separaten Eingangsleitungen zum Übertragen einer logischen 0 führt. Das Senden der entsprechenden Rechtecksignale auf den beiden separaten Eingangsleitungen muss dabei zeitlich aufeinander abgestimmt sein, damit die Bitfolge auf der Ausgangsleitung mit der gewünschten Datenübertragungsrate erfolgt. Ferner kann vorgesehen sein, dass die Signale voneinander anhängig sind. Das bedeutet, dass die "1" auf Line A ohne ein Signal von Line B keine 1 ergibt, da der differentielle Pegel von 10V dann nicht erreicht werden kann.

Nach einer optionalen Modifikation der vorliegenden Erfindung kann vorgesehen sein, dass die Sendeeinheit dazu ausgelegt ist, eine modifizierte Flanke dadurch umzusetzen, indem beim Wechsel von Low auf High mehrfach, vorzugsweise mehr als fünfmal, zwischen dem High-Zustand und einem Hochohm-Zustand umgeschaltet wird, und/oder beim Wechsel von High auf Low mehrfach, vorzugsweise mehr als fünfmal, zwischen dem Low-Zustand und einem Hochohm-Zustand umgeschaltet wird.

Durch das Umschalten zwischen dem High-Zustand bzw. dem Low-Zustand und einem Hochohm-Zustand an der Eingangsleitungen springt das Ausgangssignal des ARINC-429-Transmitters nicht unmittelbar auf den durch ihn ausgebbaren maximalen bzw. minimalen Spannungswert, sondern steigt mit einer entsprechenden Steigung auf den maximalen Spannungswert an bzw. fällt kontinuierlich mit einem entsprechenden Gefälle auf den minimalen Spannungswert ab, die Flanke des Ausgangssignals wird also verzögert.

Ferner kann dabei vorgesehen sein, dass die Sendeeinheit dazu ausgelegt ist, bei einer modifizierten Flanke für einen Wechsel zwischen Low und High mit einer Frequenz von mindestens 62,5kHz, vorzugsweise mindestens 500 kHz und bevorzugterweise mindestens 1,0 MHz zwischen dem Hochohm-Zustand und einem Low-Wert oder einem High-Wert umzuschalten.

Nach einer optionalen Fortbildung der Erfindung kann vorgesehen sein, dass die Sendeeinheit dazu ausgelegt ist, eine modifizierte Flanke so lange auszugeben, bis das Ausgangssignal des ARINC-429-Transmitters einen vordefinierten Schwellenwert, bspw. 7,5, vorzugsweise 8 V und bevorzugterweise 9 V erreicht hat.

Nach der Erfindung kann demnach also vorgesehen sein, dass die Sendeeinheit, welche die modifizierte Flanke in der Signalfolge erzeugt, um dem Ausgangssignal des ARINC-429-Transmitters die Form zu verleihen, wonach mit niedriger Datenübertragungsgeschwindigkeit gearbeitet wird, das Ausgangssignal des ARINC-429-Transmitters erfasst. Dies kann vorteilhafterweise deswegen gemacht werden, damit die Dauer der Modifikation der Flanke des Eingangssignals bzw. der Signalfolge für einen entsprechend langen Zeitraum modifiziert werden kann.

Nach der Erfindung kann vorgesehen sein, dass zum Wechseln zwischen der niedrigen Übertragungsrate und der hohen Übertragungsrate nur die ein Datenwort bildende Signalfolge des Sendeeinheit erforderlich und insbesondere kein zusätzlicher Pin zum Signalisieren eines Umschaltens der Geschwindigkeit der Übertragungsrate an der Sendeeinheit vorgesehen ist.

Nach einer weiteren vorteilhaften Modifikation der vorliegenden Erfindung kann vorgesehen sein, dass die Sendeeinheit über zwei zueinander separate Eingangsleitungen mit dem ARINC-429-Transmitter verbunden ist, und/oder der ARINC-429-Transmitter zwei Ausgangsleitungen aufweist, dessen differenzieller Spannungspegel das Ausgangssignal definiert.

Zudem kann nach einer vorteilhaften Modifikation der vorliegenden Erfindung vorgesehen sein, dass die Sendeeinheit das Ausgangssignal, insbesondere das differenzielle Ausgangssignal, des ARINC-429-Transmitters erfasst, vorzugsweise um in Abhängigkeit davon eine Dauer einer Modifikation einer Flanke eines Rechtecksignals zeitlich festzulegen.

Nach einer weiteren vorteilhaften Fortbildung der vorliegenden Erfindung kann vorgesehen sein, dass ein Tastgrad beim Umschalten zwischen dem Hochohm-Zustand und einem Low-Wert oder einem High-Wert bei einem festen Wert liegt, vorzugsweise bei 50%.

Alternativ dazu kann der Tastgrad (auch genannt: Duty Cycle) auch während dem Modifizieren einer Flanke verändert werden, bspw. derart, dass der Tastgrad am Beginn einer modifizierten Flanke einen kleineren Wert einnimmt als am Ende eines Modifizierens einer Flanke. So kann bei einem Modifizieren einer ansteigenden Flanke zum Ende hin des Modifikationsvorgangs das Verhältnis eines High-Zustands gegenüber dem Hochohm-Zustand größer sein als zu Beginn eines Modifizierens der Flanke. Analoge Überlegungen gelten natürlich auch für das Modifizieren einer fallenden Flanke.

Die Erfindung betrifft darüber hinaus ein Verfahren zum Betreiben eines ARINC-429-Transmitters, vorzugsweise mithilfe eines Systems nach einem der vorstehend beschriebenen Aspekte, wobei ein ARINC-429-Transmitter in seiner Konfiguration zum Übertragen von Daten mit hoher Übertragungsrate regulär genutzt wird, wenn Daten mit hoher Übertragungsrate zu übertragen sind, und der ARINC-429-Transmitter mit einer spezifischen Signalfolge einer Sendeeinheit beaufschlagt wird, die den ARINC-429-Transmitter dazu veranlassen, Daten mit niedriger Übertragungsrate zu übertragen, derart, dass Flanken in der Signalfolge durch ein (mehrmaliges) Umschalten zwischen einem definierten Low-Zustand oder einem definierten High-Zustand zu einem Hochohm-Zustand modifiziert werden.

Nach einer vorteilhaften Modifikation des erfindungsgemäßen Verfahrens kann vorgesehen sein, dass das Modifizieren der Flanken durch die Sendeeinheit so lange ausgeführt wird, bis das Ausgangssignal des ARINC-429-Transmitters einen vorbestimmten Schwellenwert, insbesondere Spannungs-Schwellenwert, erreicht, bspw. 7,5 V, vorzugsweise 8 V und bevorzugterweise 9 V.

Dabei kann vorteilhafterweise vorgesehen sein, dass das Modifizieren der Flanken dazu führt, dass das Ausgangssignal eine gewünschte Steigung in der abfallenden oder ansteigenden Flanke aufweist, die für eine Flanke mit niedrigerer Übertragungsgeschwindigkeit typisch ist.

Die Erfindung betrifft ferner ein Luftfahrzeug mit einem System nach einem der vorstehend beschriebenen Aspekte oder verwendend das Verfahren nach einem der vorstehend beschriebenen Aspekte.

Weitere Merkmale, Einzelheiten und Vorteile der Erfindung werden anhand der nachfolgenden Figurenbeschreibung ersichtlich. Dabei zeigen:
- Fig. 1:: eine schematische Darstellung einer Ausführungsform eines Systems zum Betreiben eines ARINC-429-Transmitters,
- Fig. 2:: eine Darstellung der Eingangs- und Ausgangssignale des ARINC-429-Transmitters bei der hohen Übertragungsgeschwindigkeit, und
- Fig.3:: eine Darstellung der Eingangs- und Ausgangssignale des ARINC-429-Transmitters für eine niedrige Übertragungsgeschwindigkeit.

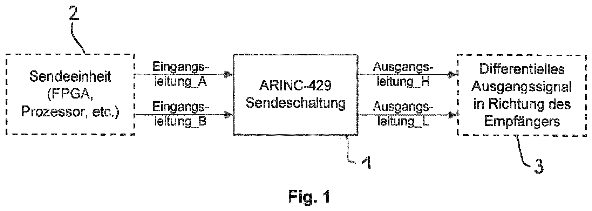

Fig. 1 zeigt eine Übersicht für das System zum Betreiben eines ARINC-429-Transmitters 1. Diese wird von einer Sendeeinheit 2 mit entsprechenden Eingangssignalen versorgt und gibt dann an einen Abnehmer 3 ein entsprechendes Ausgangssignal. Die Eingangsleitung kann dabei aus mehreren separat zueinander ausgebildeten Eingangsleitungen bestehen (Input_Line A und Input_Line_B), wie es für den ARINC-429-Standard üblich ist. Das Ausgangssignal wird ebenfalls über zwei Leitungen (Output_Line_High und Output_Line_Low) übertragen, und mithilfe einer Spannungsdifferenz zwischen diesen beiden Leitungen definiert.

Die Sendeeinheit 2 kann dabei ein FPGA, ein Prozessor oder dergleichen sein.

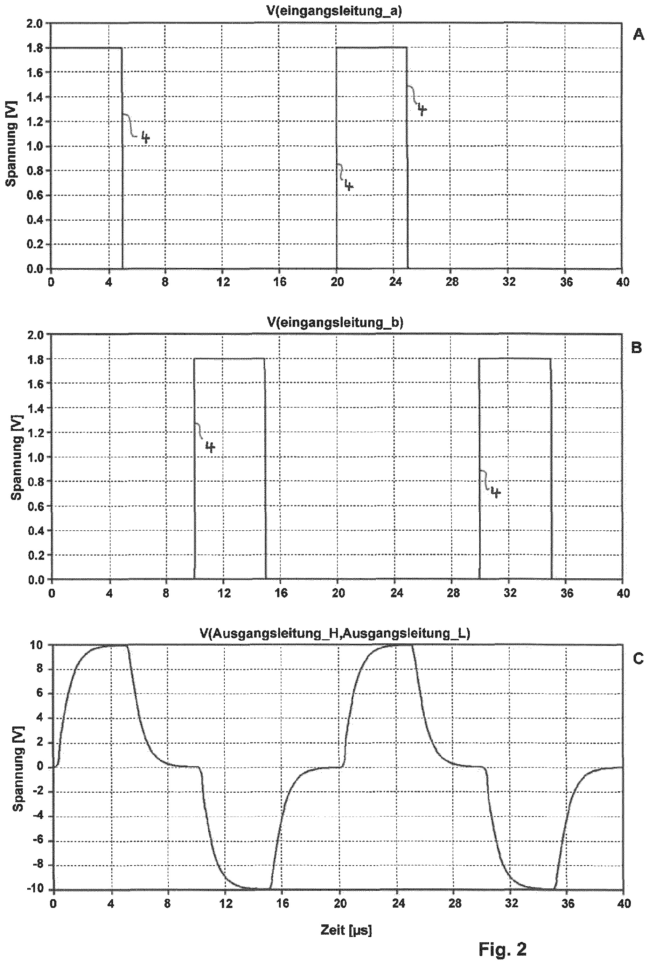

Fig. 2 zeigt dabei im unten angeordneten Diagramm C eine Bitsequenz für 100 kb/s, welche einer hohen Datenübertragungsgeschwindigkeit entspricht. Die Diagramme A und B zeigen die beiden Single-Ended-Eingangssignale der beiden Eingangssignalleitungen zum differenzielle Ausgangssignal (in Diagramm C). Aus der Sendeeinheit 1 werden die Signale über die beiden Eingangssignalleitungen (Input_Line_A und Input_Line_B) ausgegeben. Die Ausgangssignale der ARINC-429-Transmitterschaltung werden hier als differenzielles Ausgangssignal ausgegeben, welches in Diagramm C zu erkennen ist.

Mit dem erfindungsgemäßen Ansatz kann der ARINC-429-Transmitter ohne Hardwaremodifikation verschiedene Datenraten standardgetreu übertragen. Dafür bedarf es zur Übertragung unterschiedliche Signalfolgen an den Eingangsleitungen (auch genannt Bitstreams) für die verschiedenen Datenraten. Für die Übertragung mit einer hohen Geschwindigkeit werden die Zustände über eine Signalisierung mittels logisch 1 (High) und logisch 0 (Low) umgesetzt. Bei logisch 1 steigt die Flanke 4 durch einen definierten Filter an. Bei logisch 0 fällt die Flanke entsprechend ab. Die hierbei verwendete Signalfolge wird ohne Änderung gegenüber dem Standard verwendet, sodass sich volle Kompatibilität mit einem ARINC-429-Transmitter ergibt, der für die Verwendung mit einer hohen Datenübertragungsrate konfiguriert ist. Die Ausgangssignalfolge und das zugehörige Eingangssignal am Transmitter 1 sind dabei in Figur 2 zu erkennen.

Ein Rechteckimpuls (von 0-5 µs) auf einer ersten der beiden Eingangsleitungen verursacht dabei am Ausgang des Transmitters ein Signal im Bereich von 0-10 µs, welches nach dem ARINC-429-Standard für ein gesetztes Bit, also 1, steht. Ein Rechtecksignal auf der zweiten der beiden separaten Eingangsleitungen (von 10-15 µs) verursacht am Ausgangssignal (im Bereich von 10-20 µs) die charakteristische Form, welche nach dem Standard für das Bit "0" steht. Man erkennt demnach, dass die in Diagramm C von Fig. 2 dargestellte Signalisierung das Bitmuster "1010" signalisiert. Die Datenübertragungsgeschwindigkeit liegt dabei bei 100 kb/s, da jeweils 1 Bit alle 10 µs übertragen wird.

Möchte man nun den ARINC-429-Transmitter mit einer geringen Datenübertragungsgeschwindigkeit verwenden, so ist es nach der Erfindung lediglich erforderlich, die Eingangssignale zu modifizieren. Insbesondere wird dabei neben Dauer und Signalisierungszeitpunkt die Flanke bei einem Wechsel zwischen einem Low-Zustand und einem High-Zustand entsprechend modifiziert, damit sich am Ausgangssignal eine Flanke einstellt, deren Steigung derjenigen entspricht, die man erhalten würde, wenn man tatsächlich einen ARINC-429-Transmitter verwenden würde, der mit der niedrigen Datenübertragungsrate vorkonfiguriert ist.

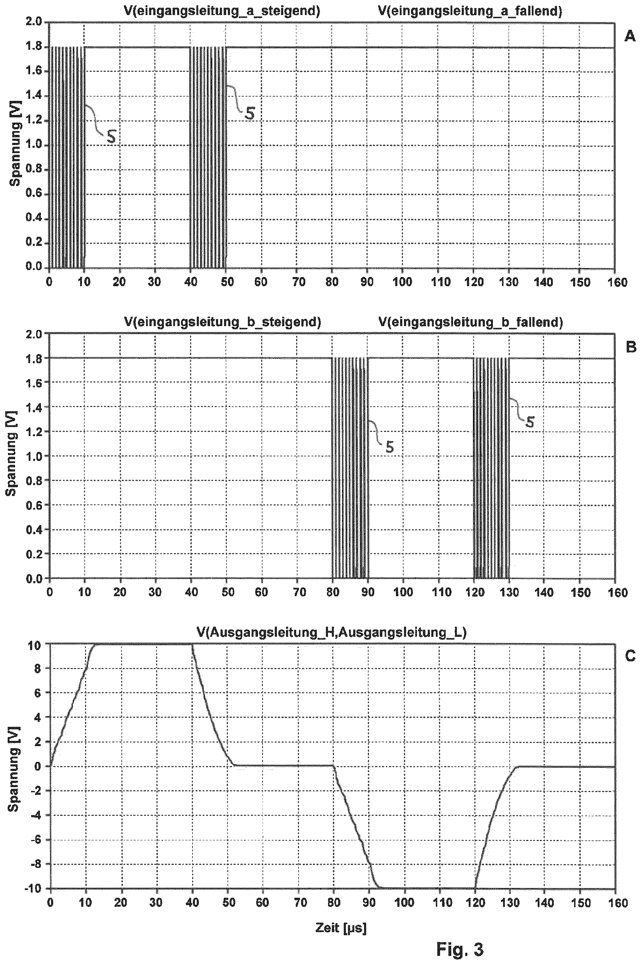

Fig. 3 zeigt hierbei die Eingangssignalfolgen zum Erreichen des gewünschten Effekts. Möchte man den ARINC-429-Transmitter nun so verwenden, dass an dessen Ausgang ein Ausgangssignal anliegt, welches typisch für eine niedrige Datenübertragungsgeschwindigkeit ist, kann nun nicht mehr länger ein einfaches Rechtecksignal als Eingangsfolge verwendet werden. Vielmehr ist dabei die Flanke 5 bei einem Wechsel zwischen einem Low-Zustand und einem High-Zustand derart zu modifizieren, dass ein mehrmaliges Umschalten auf einen Hochohm-Zustand erfolgt. So wird bspw. bei einer Flanke von Low auf High mehrmals zwischen High und dem Hochohm-Zustand umgeschaltet. Durch das Schalten zwischen diesen Zuständen wird die steigende Flanke im Ausgangssignal verzögert. Die Eingangssignalfolge besteht dabei aus variierenden An- und Auszeiten, um ein monoton steigendes Signal im Ausgangssignal zu erzeugen. Sobald der vordefinierte Soll-Spannungswert des High-Zustands erreicht wird, bleibt der Zustand bei High, bis die fallende Flanke eingeleitet wird. Bei der fallenden Flanke wechselt die Eingangssignalfolge zwischen Low und Hochohm-Zustand, um die fallende Flanke ebenfalls zu verzögern. Die Zustandswechsel erfolgen, bis die vordefinierte SollSpannung für den Low-Zustand erreicht ist. Anschließend bleibt der Zustand bei Low. Figur 3 zeigen in den Darstellungen A und B wie das Single-Ended-Transmitter Signal aussieht, wohingegen Darstellung C das differenzielle Ausgangssignal der Transmitterschaltung darstellt.

Im Diagramm C von Fig. 3 erkennt man das übertragene Bitmuster "10" mit einer Übertragungsgeschwindigkeit von 12,5 kb/s, da alle 80 µs 1 Bit übertragen wird.

## Patentansprüche

1. System zum Betreiben eines ARINC-429- kompatiblen Transmitters, umfassend:
einen ARINC-429- kompatiblen Transmitter zum Entgegennehmen einer Signalfolge von einer Sendeeinheit und zum Umwandeln der Signalfolge in ein differentielles Ausgangssignal zum Ausgeben an einen Empfänger, und
die Sendeeinheit zum Erzeugen einer Signalfolge für den ARINC-429-Transmitter,
**dadurch gekennzeichnet, dass**
der ARINC-429-Transmitter in Abhängigkeit einer empfangenen Signalfolge von der Sendeeinheit dazu ausgelegt ist, ein Ausgangssignal mit einer hohen oder einer niedrigen Übertragungsrate an den Empfänger zu senden, vorzugsweise wobei die Datenübertragungsrate bei niedriger Übertragungsrate im Bereich von 12 - 14,5 kb/s ±1% und die Datenübertragungsrate bei hoher Übertragungsrate 100 kb/s ±1% ist.

2. System nach dem vorhergehenden Anspruch 1, wobei der ARINC-429-kompatible Transmitter so konfiguriert ist, dass er dazu in der Lage ist, ein Ausgangssignal mit einer hohen Übertragungsrate an den Empfänger zu senden.

3. System nach einem der vorhergehenden Ansprüche, wobei die Sendeeinheit dazu ausgelegt ist, dann, wenn der Transmitter mit der niedrigen Übertragungsrate zu betreiben ist, die an den Transmitter zu sendende Signalfolge in ihren steigenden und fallenden Flanken zu modifizieren und/ oder eine Bitdauer zu modifizieren.

4. System nach einem der vorhergehenden Ansprüche, wobei die Signalfolge der Sendeeinheit mindestens ein Rechtecksignal, insbesondere ausschließlich Rechtecksignale, darstellt, wobei deren Flanken und/oder eine Pegeldauer des Ausgangssignals in Abhängigkeit davon, ob der Transmitter mit hoher Übertragungsrate oder mit niedriger Übertragungsrate zu betreiben ist, modifiziert sind oder nicht.

5. System nach dem vorhergehenden Anspruch 3 oder 4, wobei die Sendeeinheit dazu ausgelegt ist, eine modifizierte Flanke dadurch umzusetzen, indem beim Wechsel von Low auf High mehrfach, vorzugsweise mehr als fünfmal, zwischen dem High-Zustand und einem Hochohm-Zustand umgeschaltet wird, und/oder
beim Wechsel von High auf Low mehrfach, vorzugsweise mehr als fünfmal, zwischen dem Low-Zustand und einem Hochohm-Zustand umgeschaltet wird.

6. System nach dem vorhergehenden Anspruch 5, wobei die Sendeeinheit dazu ausgelegt ist, bei einer modifizierten Flanke für einen Wechsel zwischen Low und High mit einer Frequenz von mindestens 62,5 kHz, vorzugsweise mindestens 500 kHz und bevorzugterweise mindestens 1,0 MHz zwischen dem Hochohm-Zustand und einem Low-Wert oder einem High-Wert umzuschalten.

7. System nach einem der vorhergehenden Ansprüche 5 oder 6, wobei die Sendeeinheit dazu ausgelegt ist eine modifizierte Flanke so lange auszugeben, bis das Ausgangssignal des Transmitters einen vordefinierten Schwellenwert, bspw. 7,5 V, vorzugsweise 8 V und bevorzugterweise 9 V, erreicht hat.

8. System nach einem der vorhergehenden Ansprüche, wobei zum Wechseln zwischen der niedrigen Übertragungsrate und der hohen Übertragungsrate nur die ein Datenwort bildende Signalfolge des Sendeeinheit erforderlich und insbesondere kein zusätzlicher Pin zum Signalisieren eines Umschaltens der Geschwindigkeit der Übertragungsrate an der Sendeeinheit vorgesehen ist.

9. System nach einem der vorhergehenden Ansprüche, wobei
die Sendeeinheit über zwei zueinander separate Eingangsleitungen mit dem Transmitter verbunden ist, und/oder
der Transmitter zwei Ausgangsleitungen aufweist, dessen differenzieller Spannungspegel das Ausgangssignal definiert.

10. System nach einem der vorhergehenden Ansprüche, wobei die Sendeeinheit das Ausgangssignal, insbesondere das differenzielle Ausgangssignal, des Transmitters erfasst, vorzugsweise um in Abhängigkeit davon eine Dauer einer Modifikation einer Flanke eines Rechtecksignals zeitlich festzulegen.

11. System nach einem der vorhergehenden Ansprüche, fortgebildet mit den Merkmalen des Anspruchs 5, wobei
ein Tastgrad beim Umschalten zwischen dem Hochohm-Zustand und einem Low-Wert oder einem High-Wert bei einem festen Wert liegt, vorzugsweise bei 50% oder variabel ist.

12. Verfahren zum Betreiben eines ARINC-429-kompatiblen Transmitters, vorzugsweise mithilfe eines Systems nach einem der vorhergehenden Ansprüche, wobei:
ein ARINC-429-kompatibler Transmitter in seiner Konfiguration zum Übertragen von Daten mit hoher Übertragungsrate regulär genutzt wird, wenn Daten mit hoher Übertragungsrate zu übertragen sind, und
der ARINC-429-Transmitter mit einer spezifischen Signalfolge einer Sendeeinheit beaufschlagt wird, die den ARINC-429-Transmitter dazu veranlassen, Daten mit niedriger Übertragungsrate zu übertragen, derart, dass Flanken in der Signalfolge durch ein Umschalten zwischen einem definierten Low-Zustand oder einem definierten High-Zustand zu einem Hochohm-Zustand modifiziert werden.

13. Verfahren nach dem vorhergehenden Anspruch 12, wobei das Modifizieren der Flanken durch die Sendeeinheit so lange ausgeführt wird, bis das Ausgangssignal des ARINC-429-Transmitters einen vorbestimmten Schwellenwert, insbesondere Spannungs-Schwellenwert, erreicht, bspw. 7,5 V, vorzugsweise 8 V und bevorzugterweise 9 V.

14. Verfahren nach einem der vorhergehenden Ansprüche 12 oder 13, wobei das Modifizieren der Flanken dazu führt, dass das Ausgangssignal eine gewünschte Steigung in der abfallenden oder ansteigenden Flanke aufweist, die für eine Flanke mit niedrigerer Übertragungsgeschwindigkeit typisch ist.

15. Luftfahrzeug mit einem System nach einem der vorhergehenden Ansprüche 1-11 oder verwendend das Verfahren nach einem der vorhergehenden Ansprüche 12-14.
